# EUROPÄISCHE PATENTSCHRIFT

(11) **EP 1 111 083 B1**
(45) Veröffentlichungstag und Bekanntmachung des Hinweises auf die Patenterteilung: **18.08.2004**
(21) Anmeldenummer: 00126982.8
(22) Anmeldetag: 08.12.2000
(51) Int. Cl.: C23C 14/02, C23C 14/16, C23C 14/58, H01L 21/02, H01L 21/321

(54) **Verfahren zur Herstellung einer strukturierten Metallschicht**
Process for making a structured metal layer
Procédé de fabrication d'une couche métallique structurée

(30) Priorität: 10.12.1999 DE 19959711
(43) Veröffentlichungstag der Anmeldung: 27.06.2001
(73) Patentinhaber: Infineon Technologies AG, 81669 München (DE)
(72) Erfinder: Beitel, Gerhard, Dr., 80335 München (DE); Sänger, Annette, Dr., 01099 Dresden (DE); Hartner, Walter, 81829 München (DE)
(74) Vertreter: Ginzel, Christian

(56) Entgegenhaltungen:
- US-A- 5 714 402
- US-A- 5 789 268
- PATENT ABSTRACTS OF JAPAN vol. 1999, no. 09, 30. Juli 1999 (1999-07-30) & JP 11 121411 A (MATSUSHITA ELECTRON CORP), 30. April 1999 (1999-04-30)

## Beschreibung

Die Erfindung betrifft Verfahren zur Herstellung einer strukturierten Metallschicht, insbesondere ein Verfahren zur Herstellung einer Elektrode und insbesondere ein Verfahren zur Herstellung einer Elektrode für einen Speicherkondensator einer integrierten Speicheranordnung.

Um die in einem Speicherkondensator einer Speicherzelle gespeicherte Ladung reproduzierbar auslesen zu können, sollte die Kapazität des Speicherkondensators mindestens einen Wert von etwa 30 fF besitzen. Gleichzeitig mußte und muß die laterale Ausdehnung des Kondensators ständig verkleinert werden, um eine Erhöhung der Speicherdichte erzielen zu können. Diese an sich gegenläufigen Anforderungen an den Kondensator der Speicherzelle führten und führen zu einer immer komplexeren Strukturierung des Kondensators ("Trench-Kondensatoren", "Stack-Kondensatoren", "Kronen-Kondensatoren"), um trotz kleiner werdender lateraler Ausdehnung des Kondensators eine ausreichende Kondensatorfläche bereitstellen zu können. Dementsprechend wird jedoch die Herstellung des Kondensators immer aufwendiger und damit immer teurer.

Ein weiterer Weg, eine ausreichende Kapazität des Kondensators zu gewährleisten, liegt in der Verwendung anderer Materialien zwischen den Kondensatorelektroden. In letzter Zeit werden daher anstatt des herkömmlichen Siliziumoxids/ Siliziumnitrids neue Materialien, insbesondere hoch-ε Paraelektrika und Ferroelektrika, zwischen den Kondensatorelektroden einer Speicherzelle verwendet. Diese neuen Materialien besitzen eine deutlich höhere relative Dielektrizitätskonstante (> 20) als das herkömmliche Siliziumoxid/Siliziumnitrid (< 8). Daher kann durch den Einsatz dieser Materialien, bei gleicher Kapazität und gleicher lateraler Ausdehnung der Speicherzelle, die benötigte Kondensatorfläche und damit die benötigte Komplexität der Strukturierung des Kondensators deutlich vermindert werden. Beispielsweise kommen Bariumstrontiumtitanat (BST, (Ba,Sr)TiO₃), Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) zum Einsatz.

Neben herkömmlichen DRAM-Speicherbausteinen werden in Zukunft auch ferroelektrische Speicheranordnungen, sogenannte FRAM's, eine wichtige Rolle spielen. Ferroelektrische Speicheranordnungen besitzen gegenüber herkömmlichen Speicheranordnungen, wie beispielsweise DRAMs und SRAMs, den Vorteil, daß die gespeicherte Information auch bei einer Unterbrechung der Spannungs- bzw. Stromversorgung nicht verloren geht sondern gespeichert bleibt. Diese Nichtflüchtigkeit ferroelektrischer Speicheranordnungen beruht auf der Tatsache, daß bei ferroelektrischen Materialien die durch ein äußeres elektrisches Feld eingeprägte Polarisation auch nach Abschalten des äußeren elektrischen Feldes im wesentlichen beibehalten wird. Auch für ferroelektrische Speicheranordnungen kommen die bereits genannten neuen Materialien wie Bleizirkonattitanat (PZT, Pb(Zr,Ti)O₃) bzw. Lanthan-dotiertes Bleizirkonattitanat oder Strontiumwismuttantalat (SBT, SrBi₂Ta₂O₉) zum Einsatz.

Leider bedingt die Verwendung der neuen Paraelektrika bzw. Ferroelektrika auch die Verwendung neuer Elektrodenmaterialien. Die neuen Paraelektrika bzw. Ferroelektrika werden üblicherweise auf bereits vorhandenen Elektroden (untere Elektrode) abgeschieden. Die Prozessierung erfolgt unter hohen Temperaturen, bei denen die Materialien, aus denen normalerweise die Kondensatorelektroden bestehen, so z.B. dotiertes Polysilizium, leicht oxidiert werden und ihre elektrisch leitenden Eigenschaften verlieren, was zum Ausfall der Speicherzelle führen würde.

Wegen ihrer guten Oxidationsbeständigkeit und/oder der Ausbildung elektrisch leitfähiger Oxide gelten 4d und 5d Übergangametalle, insbesondere Edelmetalle wie Ru, Rh, Pd, Os, Ir und insbesondere Pt, als aussichtsreiche Kandidaten, die dotiertes Silizium/Polysilizium als Elektrodenmaterial ersetzen könnten.

Leider hat sich herausgestellt, daß die oben genannten, in integrierten Schaltungen neu eingesetzten Elektrodenmaterialien zu einer Klasse von Materialien gehören, die sich nur schwer strukturieren lassen. Beispielsweise gehören diese Materialien zu den chemisch nur schwer oder gar nicht ätzbaren Materialien, bei denen der Ätzabtrag, auch bei der Verwendung "reaktiver" Gase, überwiegend oder fast ausschließlich auf dem physikalischen Anteil der Ätzung beruht. Darüber hinaus erweisen sich diese Materialien auch bei der Verwendung von sogenannten CMP-Verfahren (chemical mechanical polishing) als äußerst widerstandsfähig.

Bei herkömmlichen Polierverfahren wird auf das zu polierende Substrat eine Polierlösung, eine sogenannte "Slurry", aufgebracht, welche abrasive Partikel enthält. Während des eigentlichen Poliervorgangs wird dann ein sogenanntes "Pad" gegen die Oberfläche des Substrats gedrückt und Pad und Substrat relativ zueinander bewegt. Durch den von dem Pad ausgeübten Druck werden die abrasiven Partikel gegen die Oberfläche des Substrats gedrückt, und durch die relative Bewegung von Pad und Substrat kommt es zu einem Abtrag von Material von der Oberfläche des Substrats. In der Regel hängt dabei die Geschwindigkeit des Abtrags von dem ausgeübten Druck, der relativen Geschwindigkeit und den ausgewählten abrasiven Teilchen ab. Um die Geschwindigkeit des Abtrags zu erhöhen bzw. nur ganz spezifische Materialien von der Oberfläche zu entfernen, können der Slurry chemische Komponenten hinzugegeben werden, die mit dem Material der Substratoberfläche bzw. mit einem bestimmten Material auf der Oberfläche reagieren. So werden beispielsweise bei der Erzeugung von Verdrahtungsebenen der Slurry Komponenten beigefügt, die mit dem Aluminium auf der Oberfläche reagieren. Als Ergebnis eines derartigen CMP-Schrittes erhält man eine Aluminiumverdrahtung, bei der Aluminiumstrukturen mit den Isolationsstrukturen eine ebene Oberflächen bilden. So können auf einfache und kostengünstige Weise Aluminiumleiterbahnen erzeugt werden (Damascene-Technik).

Bei den neuen Elektrodenmaterialien ist aufgrund der Inertheit der Materialien die mechanische Komponente eines CMP-Schrittes, d.h. die mechanische Wirkung der abrasiven Partikel, sehr wichtig, um die Materialien von einer Substratoberfläche zu entfernen. Dementsprechend können diese Materialien nur mit einer sehr geringen Abtragsrate von der Substratoberfläche entfernt werden. Darüber hinaus erhöht sich die Gefahr von Kratzerbildungen, welche einen Chip unbrauchbar machen können. Versuche mit sehr aggressiven chemischen Komponenten in der Slurry führten andererseits nicht zu den gewünschten Ergebnissen.

Der vorliegenden Erfindung liegt daher die Aufgabe zugrunde, ein Verfahren zur Herstellung einer strukturierten Schicht anzugeben, das es ermöglicht, auch Edelmetallelektroden zu strukturieren, und das die Nachteile der herkömmlichen Verfahren mindert bzw. vermeidet. Diese Aufgabe wird von dem Verfahren zur Herstellung einer strukturierten Schicht gemäß des unabhängigen Patentanspruchs 1 sowie des unabhängigen Patentanspruchs 8 gelöst. Die so hergestellten strukturierten Schichten werden vorzugsweise als Elektroden in Speicherzellen eingesetzt. Weitere vorteilhafte Ausführungsformen, Ausgestaltungen und Aspekte der vorliegenden Erfindung ergeben sich aus den abhängigen Patentansprüchen, der Beschreibung und den beiliegenden Zeichnungen.

Erfindungsgemäß wird ein Verfahren zur Herstellung einer strukturierten Schicht mit den folgenden Schritten bereitgestellt:
a) ein vorstrukturiertes Substrat wird bereitgestellt;
b) ein Edelmetall und ein Donormaterial, welches einen Zusatz enthält, der kein Edelmetall ist, werden in zwei oder mehr Schichten auf das vorstrukturierte Substrat aufgebracht;
c) die Schichten werden einer Wärmebehandlung bei einer Temperatur zwischen etwa 400 °C und etwa 800 °C unterworfen, so daß der Zusatz in das Edelmetall diffundiert und eine Legierungsschicht entsteht; und
d) die Legierungsschicht wird chemisch-mechanisch poliert.

Weiterhin wird erfindungsgemäß ein Verfahren zur Herstellung einer strukturierten Schicht mit den folgenden Schritten bereitgestellt:
a) ein vorstrukturiertes Substrat wird bereitgestellt;
b) ein Edelmetall und ein Zusatz, der kein Edelmetall ist, werden gleichzeitig mit einem PVD-Verfahren auf das vorstrukturierte Substrat aufgebracht; so daß eine Legierungsschicht entsteht; und
c) die Legierungsschicht wird chemisch-mechanisch poliert.

Die erfindungsgemäßen Verfahren besitzen den Vorteil, daß auch Edelmetallelektroden mittels herkömmlicher CMP-Schritte, insbesondere mit Hilfe herkömmlicher Slurries, wie sie für die Strukturierung von unedlen Metallen bereits verwendet werden, strukturiert werden können. Ohne sich einschränken zu wollen sind die Erfinder der Auffassung, daß sich dies dadurch erklären läßt, daß die chemisch aktiven Komponenten der Slurry den Zusatz zu dem Edelmetall in der Legierung angreifen, wodurch sich die Oberfläche der Legierungsschicht aufrauht und dadurch der chemisch-mechanische Abtrag des Edelmetalls erhöht wird. Jedoch bleiben die gute elektrische Leitfähigkeit und die Inertheit, insbesondere hinsichtlich Gasphasen CVD-Prozessen mit anschließenden Wärmebehandlungen, der ursprünglichen Edelmetallschicht bei der so gebildeten Legierungsschicht im wesentlichen erhalten. Erfindungsgemäß wird eine somit eine Elektrode geschaffen, welche eine sehr gute elektrische Leitfähigkeit aufweist. Darüber hinaus ist die Elektrode bei Gasphasen CVD-Abscheidungen und anschließenden Wärmebehandlungen (Annealprozessen) weitestgehend inert. Das Verhalten der Elektroden bei naßchemischen Polier- und Strukturierungsvorgängen ist jedoch durch die erfindungsgemäße Modifikation derartig verändert, daß die Elektroden mit herkömmlichen Slurries behandelbar sind.

Bevorzugt umfaßt das Donormaterial im wesentlichen nur den Zusatz. So kann beispielsweise eine reine Titanschicht auf einer Platinschicht erzeugt werden. Durch die anschließende Wärmebehandlung diffundiert das Titan in das Platin, so daß eine Platin/Titan Legierung entsteht. Als Donormaterial kann jedoch auch Titanoxidschicht (TiOₓ) verwendet werden. Durch die anschließende Wärmebehandlung diffundiert nur das Titan in das Platin, so daß einerseits eine Platin/Titan Legierung entsteht andererseits eine Titanoxidschicht mit einer anderen stöchiometrischen Zusammensetzung auf der Legierungsschicht zurückbleibt. Diese Titanoxidschicht wird durch zusätzlich Ätzschritt, beispielsweise mit HF oder HCL, von der Legierungsschicht entfernt.

Bevorzugte Edelmetalle, die in Zusammenhang mit der vorliegenden Erfindung Verwendung finden, sind die Edelmetalle aus der Nebengruppe 8b des Periodensystems der Elemente sowie Gold(Au). Zur Gruppe 8b gehören Osmium(Os), Iridium(Ir) und Platin(Pt), wobei Ir und Pt besonders bevorzugt sind.

Der Zusatz, der kein Edelmetall ist, kann bevorzugt ausgewählt werden aus Ti, Ta, W, Bi, Ir, Ru und/oder Pd.

Das Donormaterial, das den Zusatz enthält, kann bevorzugt ausgewählt werden aus Ti, TiN, Ta, TaN, W, WN, Bi, BiOₓ, IrOₓ, IrHfOₓ, RuOₓ, und/oder PdOₓ.

Als besonders wirksam und gut handhabbar hat sich erwiesen, wenn der Nichtedelmetallanteil in der Legierungsschicht zwischen etwa 5 und etwa 30 Atom-% beträgt.

Gemäß einer bevorzugten Ausführungsform wird die Legierungsschicht aus mehreren Schichten erzeugt. Es ist sowohl die Schichtenabfolge Edelmetall(EM)/Donormaterial(X) als auch die umgekehrte Abfolge X/EM möglich. Auch Mehrfache der genannten Schichtenabfolgen sind geeignet, beispielsweise EM/X/EM/X, EM/X/EM/X/EM/X etc. sowie X/EM/X/EM, X/EM/X/EM/X/EM etc. Schließlich ergeben sich die erfindungsgemäßen Vorteile auch bei einer Abfolge einer ungeradzahligen Schichtenanzahl, wie beispielsweise X/EM/X, X/EM/X/EM/X etc. und EM/X/EM/X/EM etc.

Gemäß einer weiteren bevorzugten Ausführungsform wird für das chemisch-mechanische Polieren eine Slurry verwendet, die Wasser, abrasive Partikel und zumindest ein Oxidationsmittel enthält. Insbesondere ist bevorzugt, wenn als abrasiven Partikel Al₂O₃-Partikel oder SiO₂-Partikel verwendet werden und/oder als Oxidationsmittel H₂O₂ verwendet wird. Weiterhin ist bevorzugt, wenn die Slurry zumindest einen Stabilisator, vorzugsweise Polyacrylsäure, aufweist.

Die Erfindung wird nachfolgend anhand von Figuren der Zeichnung näher dargestellt. Es zeigen:
- Fig. 1 - 8: ein Verfahren zur Herstellung einer strukturierten Schicht nach einem ersten Ausführungsbeispiel der Erfindung im Rahmen der Herstellung einer Speicherzelle,
- Fig. 9 - 12: ein weiteres Verfahren zur Herstellung einer strukturierten Schicht nach einem zweiten Ausführungsbeispiel der Erfindung, und
- Fig. 13 - 18: ein Verfahren zur Herstellung einer strukturierten Schicht nach einem dritten Ausführungsbeispiel.

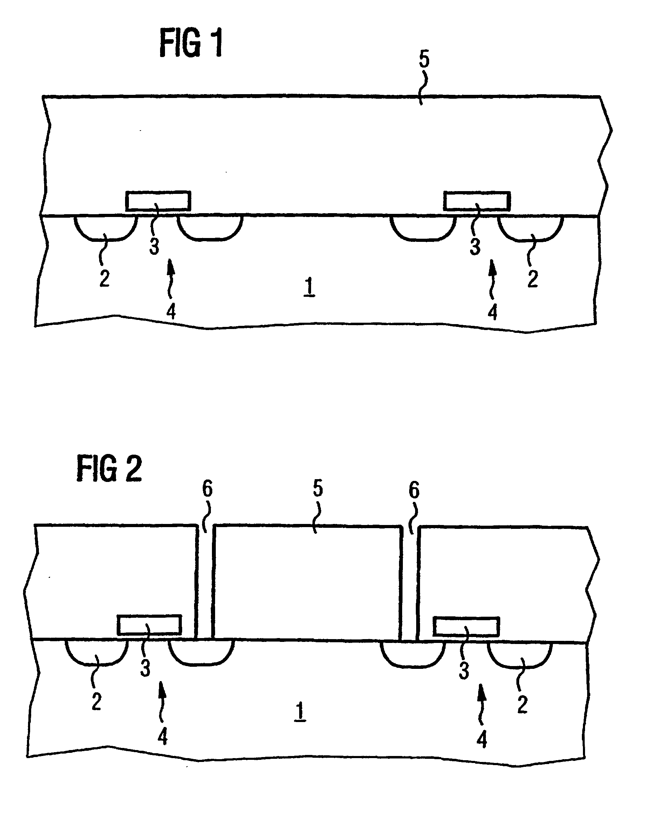

Fig. 1 zeigt ein Siliziumsubstrat 1 mit bereits fertiggestellten Transistoren 4. Die Transistoren bilden mit den noch zu erzeugenden Speicherkondensatoren die Speicherzellen, die der Speicherung der binären Informationen dienen. Die Transistoren 4 weisen jeweils zwei Diffusionsgebiete 2 auf, welche an der Oberfläche des Siliziumsubtrats 1 angeordnet sind. Zwischen den Diffusionsgebieten 2 der Transistoren 4 sind die Kanalzonen angeordnet, die durch das Gateoxid von den Gateelektroden 3 auf der Oberfläche des Siliziumsubstrats 1 getrennt sind. Die Transistoren 4 werden nach den im Stand der Technik bekannten Verfahren hergestellt, die hier nicht näher erläutert werden.

Auf das Siliziumsubtrat 1 mit den Transistoren 4 wird eine isolierende Schicht 5, beispielsweise eine Si02-Schicht aufgebracht. In Abhängigkeit des für die Herstellung der Transistoren 4 verwendeten Verfahrens können auch mehrere isolierende Schichten aufgebracht werden. Die sich daraus ergebende Struktur ist in Fig. 1 gezeigt.

Anschließend werden durch eine Phototechnik die Kontaktlöcher 6 erzeugt. Diese Kontaktlöcher 6 stellen eine Verbindung zwischen den Transistoren 4 und den noch zu erzeugenden Speicherkondensatoren her. Die Kontaktlöcher 6 werden beispielsweise durch eine anisotrope Ätzung mit fluorhaltigen Gasen erzeugt. Die sich daraus ergebende Struktur ist in Fig. 2 gezeigt.

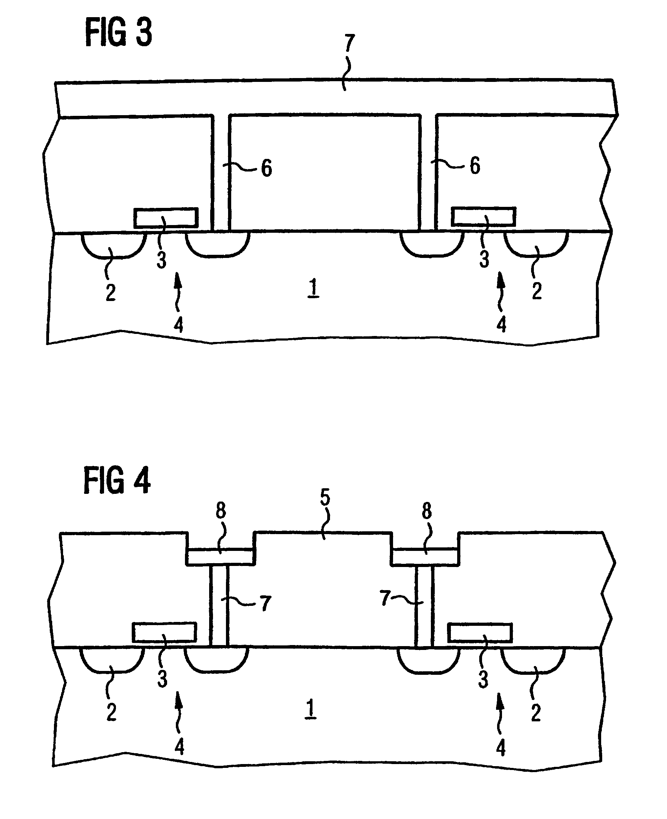

Nachfolgend wird ein leitfähiges Material 7, beispielsweise insitu dotiertes Polysilizium, auf die Struktur aufgebracht. Dies kann beispielsweise durch ein CVD-Verfahren geschehen. Durch das Aufbringen des leitfähigen Materials 7 werden die Kontaktlöcher 6 vollständig ausgefüllt und es entsteht eine zusammenhängende leitfähige Schicht auf der isolierenden Schicht 5 (Fig. 3). Anschließend folgt ein CMP-Schritt (**"C**hemical **M**echanical **P**olishing), der die zusammenhängende leitfähige Schicht auf der Oberfläche der isolierenden Schicht 5 entfernt und eine ebene Oberfläche erzeugt.

Im weiteren werden Vertiefungen in der isolierenden Schicht 5 überlappend zu den Kontaktlöchern 6 gebildet. Diese Vertiefungen werden nun mit Barrierematerial 8, beispielsweise Iridiumoxid, bis zu einer vorgegebenen Höhe gefüllt. Dies geschieht in dem das Barrierematerial 8 ganzflächig abgeschieden und nachfolgend eine anisotrope Ätzung durchgeführt wird. Die anisotrope Ätzung wird solange durchgeführt bis die vorgegebene Höhe in den Vertiefungen erreicht ist. Die sich daraus ergebende Struktur ist in Fig. 4 gezeigt.

Damit ist der erste Schritt a) des erfindungsgemäßen Verfahrens abgeschlossen. Ein vorstrukturiertes Substrat, auf das nun im folgenden das Edelmetall und/oder das Donormaterial aufgebracht werden kann, wurde bereitgestellt.

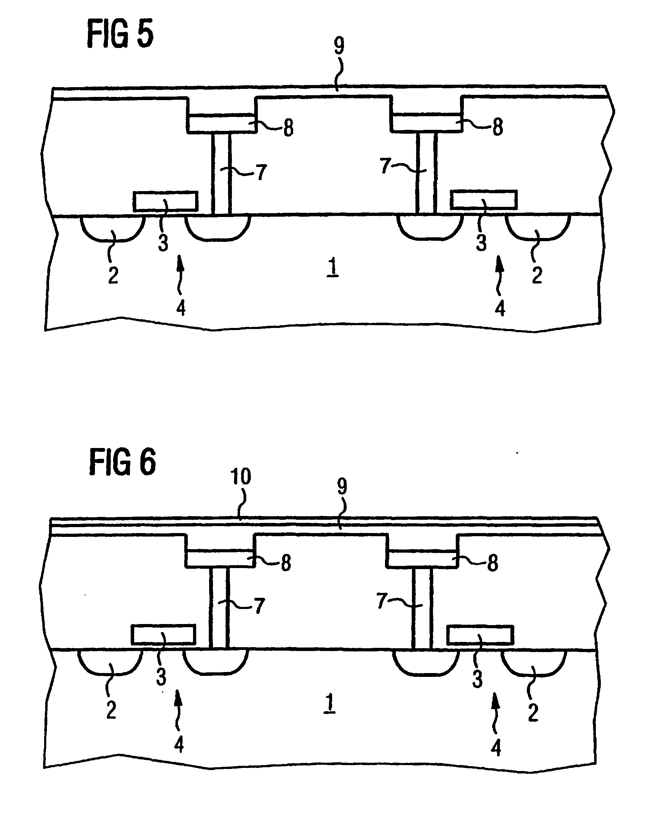

Anschließend wird bei dieser Ausführungsform der vorliegenden Erfindung ein Edelmetall, beispielsweise Platin, ganzflächig auf die in Fig. 4 gezeigte Struktur abgeschieden. Die Edelmetallschicht 9, wird durch ein Sputter-Verfahren bei einer Temperatur von etwa 500°C aufgebracht. Die sich daraus ergebende Struktur ist in Fig. 5 gezeigt. Anschließend wird eine Titanschicht 10, als Donormaterial, auf der Edelmetallschicht 9 erzeugt. Dies kann beispielsweise durch ein Sputterverfahren geschehen. Die sich daraus ergebende Struktur ist in Fig. 6 gezeigt.

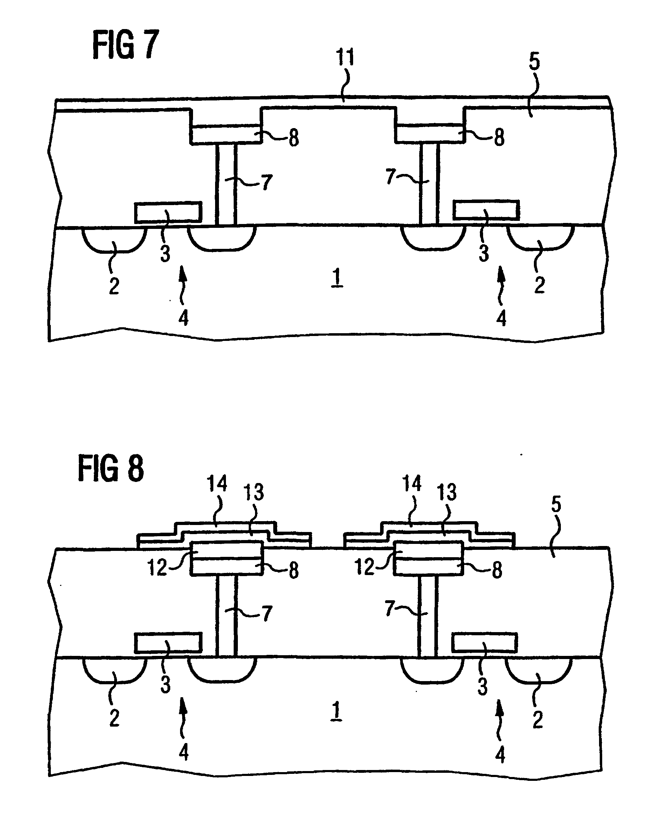

Es folgt eine Wärmebehandlung (Temperung) bei einer Temperatur von etwa 700 °C, so daß das Titan der Titanschicht 10 als Zusatz in die Platinschicht 9 diffundiert und eine Legierungsschicht 11 entsteht. Die Dicke der Titanschicht 10 ist dabei so gewählt, daß das Titan vollständig in die Platinschicht 9 diffundiert, so daß an der Oberfläche der Legierungsschicht 11 im wesentlichen kein Titan zurückbleibt. Die sich daraus ergebende Struktur ist in Fig. 7 gezeigt.

Anschließend wird ein CMP-Schritt durchgeführt, wobei die Legierungsschicht 11 von der Oberfläche des Substrats entfernt. Nur die Teile der Legierungsschicht 11, die in den Vertiefungen oberhalb der Barrieren 8 angeordnet sind, bleiben zurück. Diese Teile der Legierungsschicht 11 bilden später die unteren Elektroden 12 für die noch zu erzeugenden Kondensatoren der Speicherzellen. Für den CMP-Schritt wird beispielsweise eine Slurry mit 1 bis 5 Gewichts-% abrasiver Al₂O₃-Partikel und 2 bis 10 Gewichts-% H₂O₂ als Oxidationmittel verwendet. Die Verwendung einer herkömmlichen Slurry ist möglich, da die Eigenschaften der Legierungsschicht durch das eindiffundierte Titan so verändert sind, daß auch mit herkömmlichen Slurries ein chemomechanischer Abtrag erreicht werden kann.

Nach dem CMP-Schritt wird die isolierenden Schicht 5 durch eine anisotrope Ätzung zurückgeätzt, so daß die Elektroden 12 etwas von der Oberfläche der isolierenden Schicht 5 hervorstehen. Dies erhöht im weiteren die Kondensatorfläche des noch zu erzeugenden Speicherkondensators. Es folgt die Erzeugung einer ferroelektrischen Schicht. Ein SBT Film 13 wird mit Hilfe eines CVD Prozesses auf so vorbereitete Substrat abgeschieden. Der CVD Prozeß wird bei einer Substrattemperatur von 385°C und einem Kammerdruck von etwa 1200 Pa durchgeführt. Der Sauerstoffanteil im Gasgemisch beträgt 60%. Dabei wird der SBT Film 13 als amorpher Film abgeschieden. Dementsprechend zeigt der SBT Film 13 im wesentlichen noch keine ferroelektrischen Eigenschaften. Anschließend wird das abgeschiedene, amorphe SBT 13 bei einer Temperatur zwischen 600 bis 750°C für 10 bis 30 min in einer Sauerstoffatmosphäre getempert, wodurch die ferroelektrischen Eigenschaften der SBT 13 erzeugt werden.

Anschließend wird die obere Elektrode der Speicherkondensatoren ganzflächig abgeschieden. Wiederum werden wegen ihrer guten Oxidationsbeständigkeit und/oder der Ausbildung elektrisch leitfähiger Oxide können 4d und 5d Übergangsmetalle, insbesondere Platinmetalle (Ru, Rh, Pd, Os, Ir, Pt) und insbesondere Platin selbst, als Elektrodenmaterial eingesetzt. Die Edelmetallschicht 14, beispielsweise Platin, wird beispielsweise durch ein Sputterverfahren mit einer Sputtertemperatur von etwa 300 bis 550°C aufgebracht. Nach dem Aufbringen der oberen Elektrode wird wiederum eine Temperung durchgeführt, um die Grenzschicht zwischen der ferroelektrischen Schicht 13 und der oberen Elektrode 14 auszuheilen. Die Edelmetallschicht 14 und die ferroelektrische Schicht 13 werden anschließend mit Hilfe eines anisotropen Ätzverfahrens strukturiert, so daß die in Fig. 8 gezeigte Struktur entsteht.

Damit sind die Speicherzellen im wesentlichen fertiggestellt. Es folgenden weitere Schritte zur Isolierung der einzelnen Speicherzellen und zur Herstellung der Verdrahtung der Speicheranordnung. Die dabei verwendeten Verfahren gehören jedoch zum Stand der Technik, die hier nicht näher erläutert werden.

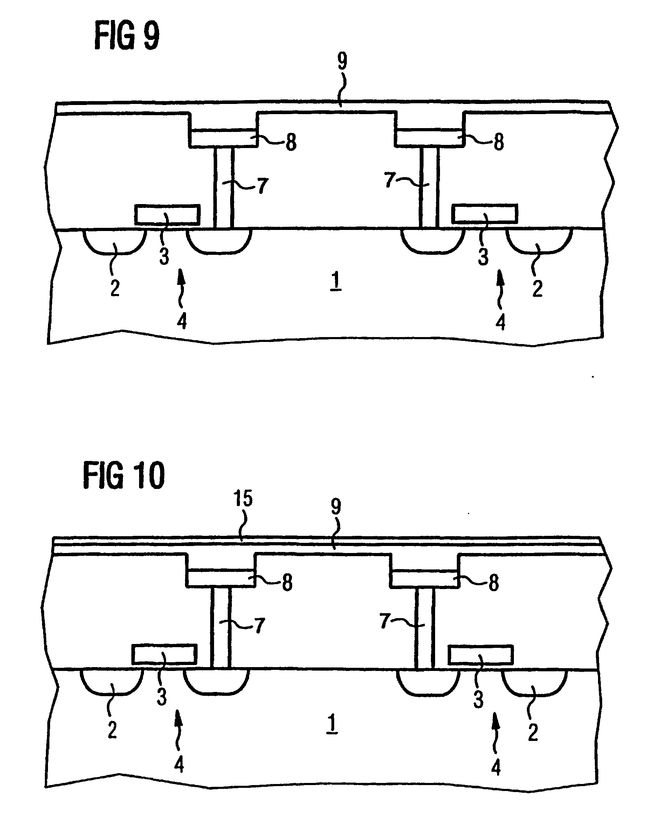

Die Figuren 9 bis 12 zeigen ein weiteres Verfahren zur Herstellung einer strukturierten Schicht nach einem zweiten Ausführungsbeispiel der Erfindung. Der erste Schritt a) des Verfahrens gemäß der zweiten Ausführungsform der vorliegenden Erfindung entspricht dabei dem, was in Zusammenhang mit den Figuren 1 bis 4 erläutert wurde, so daß auf eine Wiederholung verzichtet werden kann.

Auch bei dieser Ausführungsform der vorliegenden Erfindung wird ein Edelmetall, beispielsweise Platin, ganzflächig auf die in Fig. 4 gezeigte Struktur abgeschieden. Die Edelmetallschicht 9, wird durch ein Sputter-Verfahren bei einer Temperatur von etwa 500°C aufgebracht. Die sich daraus ergebende Struktur ist in Fig. 9 gezeigt. Anschließend wird eine Titanoxidschicht 15, als Donormaterial, auf der Edelmetallschicht 9 erzeugt. Dies kann beispielsweise durch ein CVD-Verfahren in geschehen. Die sich daraus ergebende Struktur ist in Fig. 10 gezeigt.

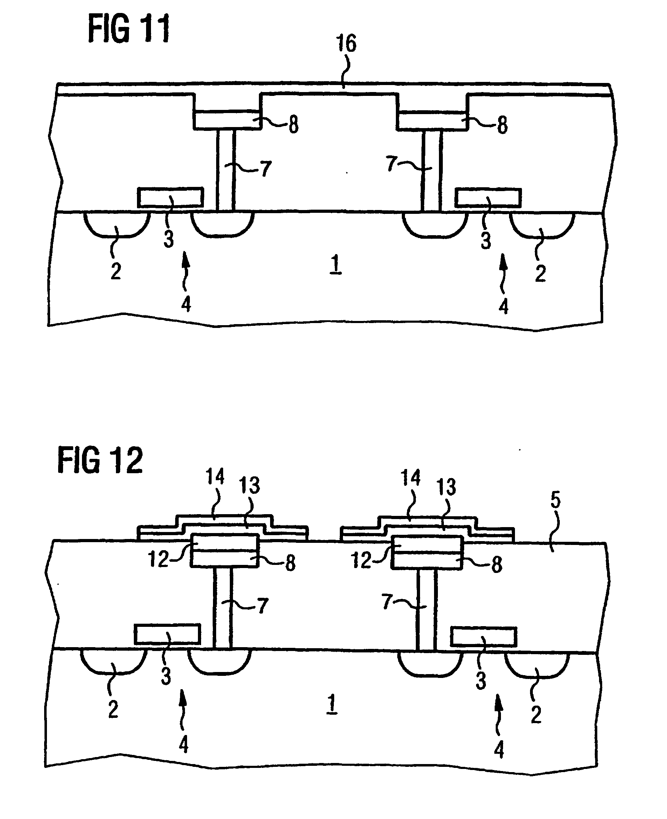

Es folgt eine Wärmebehandlung (Temperung) bei einer Temperatur von etwa 700 °C in einer Sauerstoffatmosphäre, so daß das Titan der Titanoxidschicht 15 als Zusatz in die Platinschicht 9 diffundiert und eine Legierungsschicht 16 entsteht. Ein Teil des Titans diffundiert dabei auch entlang der Korngrenzen innerhalb der Platinschicht 9. Auf dem Weg entlang der Korngrenzen wird das Titan durch den Sauerstoff der Sauerstoffatmosphäre oxidiert, so daß entlang der Korngrenzen auch Titanoxid vorhanden ist. Durch die Wärmebehandlung bleibt eine Titanoxidschicht mit einer anderen stöchiometrischen Zusammensetzung auf der Legierungsschicht zurück. Diese Titanoxidschicht wird durch einen zusätzlichen Ätzschritt, beispielsweise mit HF oder HCL, von der Legierungsschicht 16 entfernt. Die sich daraus ergebende Struktur ist in Fig. 11 gezeigt.

Anschließend wird wiederum ein CMP-Schritt durchgeführt, wobei die Legierungsschicht 16 von der Oberfläche des Substrats entfernt. Nur die Teile der Legierungsschicht 16, die in den Vertiefungen oberhalb der Barrieren 8 angeordnet sind, bleiben zurück. Diese Teile der Legierungsschicht 16 bilden später die unteren Elektroden 12 für die noch zu erzeugenden Kondensatoren der Speicherzellen. Für den CMP-Schritt wird beispielsweise eine Slurry mit 1 bis 5 Gewichts % abrasiver Al₂O₃-Partikel und 2 bis 10 Gewichts-% H₂O₂ als Oxidationmittel verwendet. Die Verwendung einer herkömmlichen Slurry ist möglich, da die Eigenschaften der Legierungsschicht durch das eindiffundierte Titan sowie das Titanoxid so verändert sind, daß auch mit herkömmlichen Slurries ein chemomechanischer Abtrag erreicht werden kann.

Es folgen wiederum das Zurückätzen der isolierenden Schicht 5, das Aufbringen und Tempern der ferroelektrischen Schicht 13 sowie das Aufbringen der oberen Elektrode 14 und das Strukturieren der oberen Elektrode 14 und der ferroelektrischen Schicht 13, so daß sich die Figur 12 gezeigte Situation ergibt.

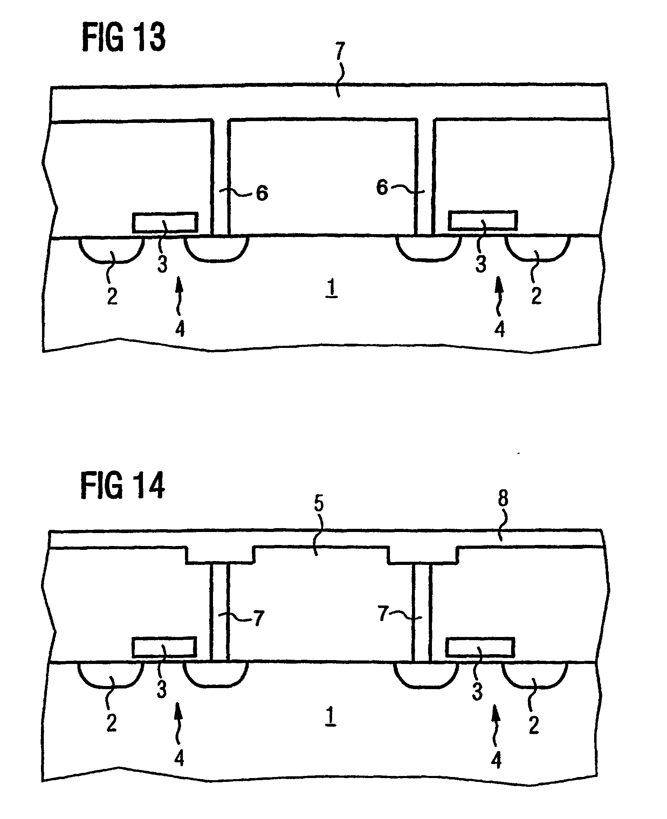

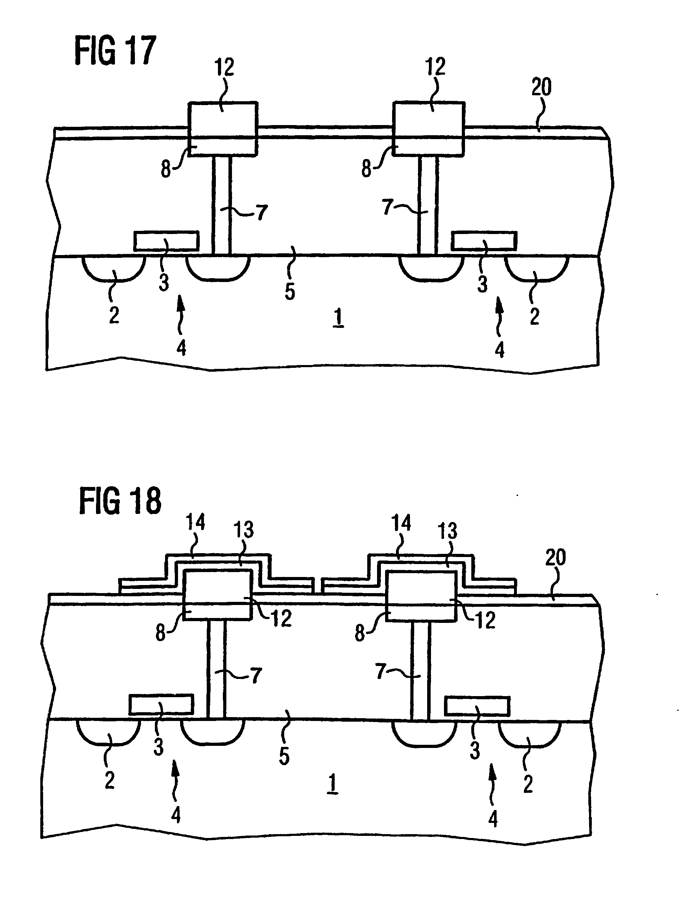

Die Figuren 13 bis 18 zeigen ein weiteres Verfahren zur Herstellung einer strukturierten Schicht nach einem dritten Ausführungsbeispiel der Erfindung. Der ersten Schritte des Verfahrens entsprichen dabei dem, was in Zusammenhang mit den Figuren 1 bis 2 erläutert wurde, so daß auf eine Wiederholung verzichtet werden kann.

Leitfähiges Material 7, beispielsweise insitu dotiertes Polysilizium, wird nun auf die Struktur aufgebracht. Dies kann beispielsweise durch ein CVD-Verfahren geschehen. Durch das Aufbringen des leitfähigen Materials 7 werden die Kontaktlöcher 6 vollständig ausgefüllt und es entsteht eine zusammenhängende leitfähige Schicht auf der isolierenden Schicht 5 (Fig. 13). Anschließend folgt ein CMP-Schritt (**"C**hemical **M**echanical **P**olishing), der die zusammenhängende leitfähige Schicht auf der Oberfläche der isolierenden Schicht 5 entfernt und eine ebene Oberfläche erzeugt.

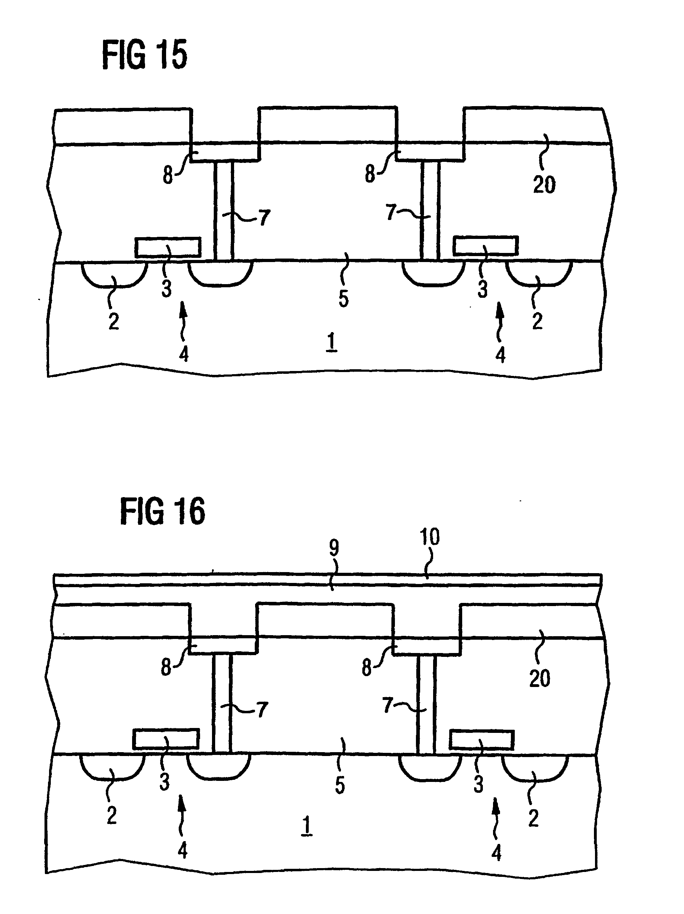

Im weiteren werden Vertiefungen in der isolierenden Schicht 5 überlappend zu den Kontaktlöchern 6 gebildet. Diese Vertiefungen werden nun mit Barrierematerial 8, beispielsweise Iridiumoxid, bis zu einer vorgegebenen Höhe gefüllt. Dies geschieht in dem das Barrierematerial 8 ganzflächig abgeschieden (Fig. 14) und nachfolgend ein CMP-Schritt durchgeführt wird. Geeignete CMP-Verfahren sind beispielsweise in der Anmeldung beschrieben, auf die hiermit Bezug genommen wird. Anschließend wird eine weitere isolierende Schicht 20, beispielsweise SiO₂, abgeschieden, welche entsprechend der noch zu erzeugenden Elektroden 12 strukturiert wird. Die sich daraus ergebende Struktur ist in Fig. 15 gezeigt.

Damit ist der erste Schritt a) des erfindungsgemäßen Verfahrens abgeschlossen. Ein vorstrukturiertes Substrat, auf das nun im folgenden das Edelmetall und/oder das Donormaterial aufgebracht werden kann, wurde bereitgestellt.

Anschließend wird bei dieser Ausführungsform der vorliegenden Erfindung ein Edelmetall, beispielsweise Platin, ganzflächig auf die in Fig. 15 gezeigte Struktur abgeschieden. Die Edelmetallschicht 9, wird durch ein Sputter-Verfahren bei einer Temperatur von etwa 500°C aufgebracht. Anschließend wird eine Titanschicht 10, als Donormaterial, auf der Edelmetallschicht 9 erzeugt. Dies kann beispielsweise durch ein Sputterverfahren geschehen. Die sich daraus ergebende Struktur ist in Fig. 16 gezeigt.

Es folgt eine Wärmebehandlung (Temperung) bei einer Temperatur von etwa 700 °C, so daß das Titan der Titanschicht 10 als Zusatz in die Platinschicht 9 diffundiert und eine Legierungsschicht entsteht. Die Dicke der Titanschicht 10 ist dabei so gewählt, daß das Titan vollständig in die Platinschicht 9 diffundiert, so daß an der Oberfläche der Legierungsschicht im wesentlichen kein Titan zurückbleibt.

Anschließend wird ein CMP-Schritt durchgeführt, wobei die Legierungsschicht von der Oberfläche des Substrats entfernt. Nur die Teile der Legierungsschicht, die in den Vertiefungen in der isolierenden Schicht 20 oberhalb der Barrieren 8 angeordnet sind, bleiben zurück. Diese Teile der Legierungsschicht bilden später die unteren Elektroden 12 für die noch zu erzeugenden Kondensatoren der Speicherzellen. Für den CMP-Schritt wird beispielsweise eine Slurry mit 1 bis 5 Gewichts-% abrasiver Al₂O₃-Partikel und 2 bis 10 Gewichts-% H₂O₂ als Oxidationmittel verwendet. Die Verwendung einer herkömmlichen Slurry ist möglich, da die Eigenschaften der Legierungsschicht durch das eindiffundierte Titan so verändert sind, daß auch mit herkömmlichen Slurries ein chemomechanischer Abtrag erreicht werden kann.

Nach dem CMP-Schritt wird die isolierenden Schicht 20 durch eine anisotrope Ätzung zurückgeätzt, so daß die Elektroden 12 etwas von der Oberfläche der isolierenden Schicht 20 hervorstehen. Dies erhöht im weiteren die Kondensatorfläche des noch zu erzeugenden Speicherkondensators. Es folgt wiederum das Aufbringen und Tempern der ferroelektrischen Schicht 13 sowie das Aufbringen der oberen Elektrode 14 und das Strukturieren der oberen Elektrode 14 und der ferroelektrischen Schicht 13, so daß sich die Figur 12 gezeigte Situation ergibt.

## Patentansprüche

1. Verfahren zur Herstellung einer struktierten Schicht mit den folgenden Schritten:
a) ein vorstrukturiertes Substrat wird bereitgestellt;
b) ein Edelmetall und ein Donormaterial, welches einen Zusatz enthält, der kein Edelmetall ist, werden in zwei oder mehr Schichten auf das vorstrukturierte Substrat aufgebracht;
c) die Schichten werden einer Wärmebehandlung bei einer Temperatur zwischen etwa 400 °C und etwa 800 °C unterworfen, so daß der Zusatz in das Edelmetall diffundiert und eine Legierungsschicht entsteht; und
d) die Legierungsschicht wird chemisch-mechanisch poliert.

2. Verfahren nach Anspruch 1,
**dadurch gekennzeichnet, daß**
das Donormaterial im wesentlichen nur den Zusatz umfaßt.

3. Verfahren nach Anspruch 1 oder 2,
**dadurch gekennzeichnet , daß**
das Donormaterial vor dem Edelmetall auf das Substrat aufgebracht wird.

4. Verfahren nach Anspruch 2,
**dadurch gekennzeichnet, daß**
mehrere Schichten des Donormaterials und zumindest eine Schicht des Edelmetalls abwechselnd aufgebracht werden, wobei mit einer Schicht des Donormaterials begonnen wird.

5. Verfahren nach Anspruch 1 oder 2,
**dadurch gekennzeichnet, daß**
das Edelmetall vor dem Donormaterial auf das Substrat aufgebracht wird.

6. Verfahren nach Anspruch 2,
**dadurch gekennzeichnet, daß**
mehrere Schichten des Edelmetalls und zumindest eine Schicht des Donormaterials abwechselnd aufgebracht werden, wobei mit einer Schicht des Edelmetalls begonnen wird.

7. Verfahren nach einem der Ansprüche 2 bis 6,
**dadurch gekennzeichnet, daß**
die Dicke der Donormaterials so gewählt ist, daß bei bei der Wärmebehandlung das Donormaterial im wesentlichen vollständig in die Edelmetall diffundiert.

8. Verfahren zur Herstellung einer struktierten Schicht mit den folgenden Schritten:
a) ein vorstrukturiertes Substrat wird bereitgestellt;
b) ein Edelmetall und ein Zusatz, der kein Edelmetall ist, werden gleichzeitig mit einem PVD-Verfahren auf das vorstrukturierte Substrat aufgebracht; so daß eine Legierungsschicht entsteht; und
c) die Legierungsschicht wird chemisch-mechanisch poliert.

9. Verfahren nach einem der vorherstehenden Ansprüche,
**dadurch gekennzeichnet, daß**
das Edelmetall ein Element aus der Gruppe 8b des Periodensystems und/oder Au ist.

10. Verfahren nach Anspruch 9,
**dadurch gekennzeichnet, daß**
das Edelmetall aus der Gruppe 8b des Periodensystems Pt und/oder Ir ist.

11. Verfahren nach einem der vorherstehenden Ansprüche,
**dadurch gekennzeichnet, daß**
der Zusatz Ti, TiOₓ, Ta, W, Bi, Ir, IrOₓ, Ru und/oder Pd ist.

12. Verfahren nach einem der vorherstehenden Ansprüche,
**dadurch gekennzeichnet, daß**
das Donormaterial Ti, TiOₓ, TiN, Ta, TaN, W, WN, Bi, BiOₓ, IrOₓ, IrHfOₓ, RuOₓ und/oder PdOₓ ist.

13. Verfahren nach einem der vorherstehenden Ansprüche,
**dadurch gekennzeichnet, daß**
die sich ergenbende Schicht zwischen etwa 5 und etwa 30 Atom-% des Donorstoffs enthält.

14. Verfahren nach einem der vorherstehenden Ansprüche,
**dadurch gekennzeichnet, daß**
für das chemisch-mechanische Polieren eine Slurry verwendet wird, die Wasser, abrasive Partikel und zumindest ein Oxidationsmittel enthält.

15. Verfahren nach Anspruch 13,
**dadurch gekennzeichnet, daß**
als abrasiven Partikel Al₂O₃-Partikel oder SiO₂-Partikel verwendet werden.

16. Verfahren nach Anspruch 13 oder 14,
**dadurch gekennzeichnet, daß**
als abrasiven Partikel eine Größe von etwa 50 bis 300 nm aufweisen.

17. Verfahren nach einem der Ansprüche 13 bis 15,
**dadurch gekennzeichnet, daß**
als Oxidationsmittel H₂O₂ verwendet wird.

18. Verfahren nach einem der Ansprüche 13 bis 16,
**dadurch gekennzeichnet, daß**
die Slurry zumindest einen Stabilisator, vorzugsweise Polyacrylsäure, aufweist.

## Claims

1. Methods for producing a structured layer, having the following steps:
a) a prestructured substrate is provided;
b) a precious metal and a donor material which contains an additive which is not a precious metal are applied in two or more layers to the prestructured substrate;
c) the layers are subjected to heat treatment at a temperature of between approximately 400°C and approximately 800°C, such that the additive diffuses into the precious metal and an alloy layer is produced; and
d) the alloy layer is polished by chemical and mechanical means.

2. Methods according to in Claim 1, **characterized in that** the donor material essentially comprises only the additive.

3. Methods according to in Claim 1 or 2, **characterized in that** the donor material is applied to the substrate before the precious metal.

4. Methods according to in Claim 2, **characterized in that** several layers of the donor material and at least one layer of the precious metal are applied alternately, starting with a layer of the donor material.

5. Methods according to in Claim 1 or 2, **characterized in that** the precious metal is applied to the substrate before the donor material.

6. Methods according to in Claim 2, **characterized in that** several layers of the precious metal and at least one layer of the donor material are applied alternately, starting with a layer of the precious metal.

7. Methods according to in one of Claims 2 to 6, **characterized in that** the thickness of the donor material is selected such that during heat treatment the donor material essentially diffuses completely into the precious metal.

8. Methods for producing a structured layer, having the following steps:
a) a prestructured substrate is provided;
b) a precious metal and an additive which is not a precious metal are simultaneously applied to the prestructured substrate using a PVD method such that an alloy layer is produced; and
c) the alloy layer is polished by chemical and mechanical means.

9. Methods according to in one of the preceding Claims, **characterized in that** the precious metal is an element from Group 8b of the Periodic Table of the Elements and/or is Au.

10. Methods according to in Claim 9, **characterized in that** the precious metal from Group 8b of the Periodic Table of the Elements is Pt and/or Ir.

11. Methods according to in one of the preceding claims, **characterized in that** the additive is Ti, TiOₓ, Ta, W, Bi, Ir, IrOₓ, Ru and/or Pd.

12. Methods according to in one of the preceding claims, **characterized in that** the donor material is Ti, TiOₓ, TiN, Ta, TaN, W, WN, Bi, BiOₓ, IrOₓ, IrHfOₓ, RuOₓ and/or PdOₓ.

13. Methods according to in one of the preceding claims, **characterized in that** the layer produced contains between approximately 5 and approximately 30 Atom% of the donor material.

14. Methods according to in one of the preceding claims, **characterized in that** a slurry containing water, abrasive particles and at least one oxidant is used for the chemical mechanical polishing.

15. Methods according to in Claim 13, **characterized in that** Al₂O₃ particles or SiO₂ particles are used as abrasive particles.

16. Methods according to in Claim 13 or 14, **characterized in that** the abrasive particles have a size of approximately 50 to 300 nm.

17. Methods according to in one of Claims 13 to 15, **characterized in that** H₂O₂ is used as oxidant.

18. Methods according to in one of Claims 13 to 16, **characterized in that** the slurry has at least one stabilizer, preferably polyacrylic acid.

## Revendications

1. Procédé de production d'une couche structurée comprenant les stades suivants :
a) on se procure un substrat structuré au préalable ;
b) on dépose un métal précieux et une matière donneuse qui contient un additif qui n'est pas un métal précieux en deux couches ou en plusieurs couches sur le substrat structuré au préalable ;
c) on soumet les couches à un traitement thermique à une température comprise entre environ 400°C et environ 800°C, de sorte que l'additif diffuse dans le métal précieux et qu'il se forme une couche d'alliage ; et
d) on polit par voie chémiomécanique la couche d'alliage.

2. Procédé suivant la revendication 1,
**caractérisé en ce que** la matière donneuse comprend sensiblement seulement l'additif.

3. Procédé suivant la revendication 1 ou 2,
**caractérisé en ce qu'**on dépose la matière donneuse sur le substrat avant le métal précieux.

4. Procédé suivant la revendication 2,
**caractérisé en ce que** l'on dépose plusieurs couches de la matière donneuse et au moins une couche du métal précieux en alternance, en commençant par une couche de la matière donneuse.

5. Procédé suivant la revendication 1 ou 2,
**caractérisé en ce que** l'on dépose le métal précieux sur le substrat avant la matière donneuse.

6. Procédé suivant la revendication 2,
**caractérisé en ce que** l'on dépose plusieurs couches du métal précieux et au moins une couche de la matière donneuse en alternance, en commençant par une couche du métal précieux.

7. Procédé suivant l'une des revendications 2 à 6,
**caractérisé en ce que** l'on choisit l'épaisseur de la matière donneuse de façon à ce que, lors du traitement thermique, la matière donneuse diffuse sensiblement complètement dans le métal précieux.

8. Procédé de production d'une couche structurée comprenant les stades suivants :
a) on se procure un substrat structuré à l'avance ;
b) on dépose un métal précieux et un additif qui n'est pas un métal précieux simultanément par un procédé PVD sur le substrat structuré à l'avance, de manière à former une couche d'alliage ; et
c) on polit par voie chémiomécanique la couche d'alliage.

9. Procédé suivant l'une des revendications précédentes,
**caractérisé en ce que** le métal précieux est un élément du groupe 8b de la classification périodique des éléments et/ou Au.

10. Procédé suivant la revendication 9,
**caractérisé en ce que** le métal précieux du groupe 8b de la classification périodique des éléments est Pt et/ou Ir.

11. Procédé suivant l'une des revendications précédentes,
**caractérisé en ce que** l'additif est Ti, TiOₓ, Ta, W, Bi, Ir, IrOₓ, Ru et/ou Pd.

12. Procédé suivant l'une des revendications précédentes,
**caractérisé en ce que** la matière donneuse est Ti, TiOₓ, TiN, Ta, TaN, W, WN, Bi, BiOₓ, IrOₓ, IrHfOₓ, RuOₓ et/ou PdOₓ.

13. Procédé suivant l'une des revendications précédentes,
**caractérisé en ce que** la couche se produisant contient entre environ 5 et environ 30 % en atomes de la substance donneuse.

14. Procédé suivant l'une des revendications précédentes,
**caractérisé en ce qu'**on utilise pour le polissage par voie chémiomécanique une suspension qui contient de l'eau, des particules abrasives et au moins un agent oxydant.

15. Procédé suivant la revendication 13,
**caractérisé en ce que** l'on utilise comme particule abrasive des particules d'Al₂O₃ ou des particules de SiO₂.

16. Procédé suivant la revendication 13 ou 14,
**caractérisé en ce que** les particules abrasives ont une dimension comprise entre environ 50 et 300 nm.

17. Procédé suivant l'une des revendications 13 à 15,
**caractérisé en ce qu'**on utilise comme agent oxydant H₂O₂.

18. Procédé suivant l'une des revendications 13 à 16,
**caractérisé en ce que** la suspension comprend au moins un agent stabilisant, de préférence de l'acide polyacrylique.
